# EUROPEAN PATENT APPLICATION

(11) **EP 4 550 977 A1**
(43) Date of publication of application: **07.05.2025**
(21) Application number: 24315479.6
(22) Date of filing: 17.10.2024
(51) Int. Cl.: H10D 30/01, H01L 21/30, H10D 30/47, H10D 62/17, H10D 64/00

(54) **IN SITU PLASMA TREATMENT BEFORE AL2O3 DEPOSITION FOR IMPROVED RON**

(30) Priority: 30.10.2023 US 202318385067
(71) Applicant: STMicroelectronics International N.V., 1228 Plan-les-Ouates, Geneva (CH)
(72) Inventor: Iucolano, Ferdinando, 95030 GRAVINA DI CATANIA (CT) (IT); Tringali, Cristina, 96011 AUGUSTA (SR) (IT); Castagna, Maria Eloisa, 95123 CATANIA (IT); Giorgino, Giovanni, 95041 CALTAGIRONE (CT) (IT); Constant, Aurore, 37100 TOURS (FR); Guillon, Virgil, 37100 TOURS (FR)
(74) Representative: Studio Torta S.p.A.

(57) **Abstract**

Methods, systems, and apparatuses for normally off HEMT are provided, including for in situ plasma treatment before Al2O3 deposition for improved on on-hydrogen-based resistance. An exemplary method may include providing a wafer comprising a AlGaN layer and a p-GaN layer; etching the p-GaN layer to form a p-GaN gate; depositing a first aluminum oxide layer over the p-GaN gate; depositing a silicon dioxide layer over the aluminum layer; etching the silicon dioxide layer and the aluminum oxide layer to expose a first portion of the AlGaN layer starting a first distance from the p-GaN gate; treating the first portion of the AlGaN layer with an in-situ hydrogen-based plasma treatment, wherein the in situ plasma treatment deactivates magnesium in the first portion of the AlGaN layer; and forming at least a first normally-off HEMT, wherein the gate of the normally-off HEMT is the first p-GaN gate.

## Description

### TECHNOLOGICAL FIELD

The present invention relates generally to high electron mobility transistors (HEMT), including manufacturing with an in-situ hydrogen-based plasma treatment before Al2O3 deposition for improved Ron during manufacturing.

### BACKGROUND

GaN HEMT are normally depletion mode transistors, which may be referred to as normally-off HEMTs. These normally-off HEMTs may use GaN with p-doping to form p-GaN gates for the normally-off HEMTs. However, the manufacturing of p-GaN may cause the sheet resistance of an AlGaN layer in the HEMT to be increased.

Thus, an aim of the invention is to overcome at least in part the above-mentioned issues.

### SUMMARY

The present invention provides a method for manufacturing an integrated circuit and a normally-off HEMT, as defined in the appended claims.

Various embodiments described herein relate to high electron mobility transistors (HEMT), including manufacturing with an in situ plasma treatment.

A method for manufacturing an integrated circuit may comprise providing a wafer comprising a AlGaN layer with a first surface and a p-GaN layer on the first of the AlGaN layer; etching the p-GaN layer to form at least a first p-GaN gate; depositing a first aluminum oxide layer over the first p-GaN gate; depositing a first silicon dioxide layer over the first aluminum oxide layer; etching the first silicon dioxide layer and the first aluminum oxide layer to expose a first portion of the AlGaN layer starting a first distance from the first p-GaN gate; treating the first portion of the AlGaN layer with an in-situ plasma hydrogen-based treatment, wherein the in situ plasma treatment containing hydrogen deactivates magnesium in the first portion of the AlGaN layer; and forming at least a first normally-off HEMT, wherein the gate of the normally-off HEMT is the first p-GaN gate.

In some embodiments, forming the first normally-off HEMT comprises depositing at least a second aluminum oxide layer and a second silicon dioxide layer.

In some embodiments, treating the first portion of the AlGaN layer with an in-situ plasma treatment does not deactivate the Mg in another portion of the AlGaN layer associated under the first p-GaN gate.

In some embodiments, the in-situ plasma treatment comprises diffusing hydrogen into the first portion of the AlGaN layer.

In some embodiments, the first distance is at least 200 nm.

In some embodiments, forming the first normally-off HEMT further comprises depositing metallization layers associated with a first normally-off HEMT gate, a first normally-off HEMT source, and a first normally-off HEMT drain.

In some embodiments, forming the first normally-off HEMT further comprises depositing at least a first metal shielding layer.

In some embodiments, the p-GaN gate comprises a TiN layer.

In some embodiments, the method further comprises depositing, after etching the first silicon dioxide layer and the first aluminum oxide layer but prior to the in-situ plasma treatment, a third aluminum oxide layer over the p-GaN gate.

In some embodiments, etching the first silicon dioxide layer and the first aluminum oxide layer further exposes a second portion of the AlGaN layer a second distance from a second side of the p-GaN gate; and treating the first portion of the AlGaN layer with an in-situ plasma hydrogen-based treatment further comprises treating the second portion of the AlGaN layer with the in-situ plasma hydrogen-based treatment.

A normally off HEMT comprises a p-GaN gate on an AlGaN layer; wherein the p-GaN gate is covered by a first aluminum oxide layer and a first silicon dioxide layer; wherein the AlGaN layer is comprised of a first portion of the AlGaN layer starting a first distance from the first p-GaN gate, and where the first portion of the AlGaN layer is not covered by the first aluminum oxide layer or the first silicon dioxide layer; and wherein the first portion of the AlGaN layer has deactivated Mg from an in situ plasma treatment.

In some embodiments, the normally off HEMT further comprises at least a second aluminum oxide layer and a second silicon dioxide layer.

In some embodiments, in another portion of the AlGaN layer associated under the first p-GaN gate comprises Mg that is not deactivated.

In some embodiments, the deactivated Mg is comprised of Mg-H complexes from diffused hydrogen from the in situ plasma treatment.

In some embodiments, the first distance is at least 200 nm.

In some embodiments, the normally off HEMT further comprises a plurality of metallization layers including a first metallization layer associated with a first normally-off HEMT gate, a second metallization layer associated with a first normally-off HEMT source, and a third metallization layer associated with a first normally-off HEMT drain.

In some embodiments, the normally off HEMT further comprises at least one metal shielding layer.

In some embodiments, the p-GaN gate comprises a TiN layer.

In some embodiments, the normally off HEMT further comprises a third aluminum oxide layer of the p-GaN gate.

In some embodiments, the AlGaN layer is further comprised of a second portion of the AlGaN layer starting a second distance from the first p-GaN gate on an opposite side of the p-GaN gate then the first portion of the AlGaN layer, and where the second portion of the AlGaN layer is not covered by the first aluminum oxide layer or the first silicon dioxide layer; and the second portion of the AlGaN layer has deactivated Mg from the in-situ plasma hydrogen-based treatment.

The above-described embodiments are provided merely for purposes of summarizing some example embodiments of the inventions; however, modifications and variations may be provided without departing from the scope of the invention, as defined in the appended claims.

### BRIEF DESCRIPTION OF THE DRAWINGS

Having thus described certain example embodiments of the present invention in general terms, reference will now be made to the accompanying drawings, which are not necessarily drawn to scale, and wherein:
FIG. 1 illustrates a first cross-section view of a block diagram of a first exemplary power device in accordance with one or more embodiments of the present invention;
FIG. 2 illustrates a first example flowchart of operations for manufacturing a power device in accordance with one or more embodiments of the present invention;
FIGs. 3A-3H illustrate example block diagrams associated with operations for manufacturing a power device in accordance with one or more embodiments of the present invention;
FIG. 4 illustrates a second example flowchart of operations for manufacturing a power device in accordance with one or more embodiments of the present invention;
FIGs. 5A-5C illustrate example block diagrams associated with operations for manufacturing a power device in accordance with one or more embodiments of the present invention;
FIG. 6 illustrates a third example flowchart of operations for manufacturing a power device in accordance with one or more embodiments of the present invention; and
FIGs. 7A-7C illustrate example block diagrams associated with operations for manufacturing a power device in accordance with one or more embodiments of the present invention.

### DETAILED DESCRIPTION

Some embodiments of the present disclosure will now be described more fully herein with reference to the accompanying drawings, in which some, but not all, embodiments of the disclosure are shown. Like reference numerals refer to like elements throughout.

As used herein, the term "comprising" means including but not limited to and should be interpreted in the manner it is typically used in the patent context. Use of broader terms such as comprises, includes, and having should be understood to provide support for narrower terms such as consisting of, consisting essentially of, and comprised substantially of.

The phrases "in various embodiments," "in one embodiment," "according to one embodiment," "in some embodiments," and the like generally mean that the particular feature, structure, or characteristic following the phrase may be included in at least one embodiment of the present invention and may be included in more than one embodiment of the present invention (importantly, such phrases do not necessarily refer to the same embodiment).

The word "example" or "exemplary" is used herein to mean "serving as an example, instance, or illustration." Any implementation described herein as "exemplary" is not necessarily to be construed as preferred or advantageous over other implementations.

If the specification states a component or feature "may," "can," "could," "should," "would," "preferably," "possibly," "typically," "optionally," "for example," "often," or "might" (or other such language) be included or have a characteristic, that a specific component or feature is not required to be included or to have the characteristic. Such a component or feature may be optionally included in some embodiments or it may be excluded.

The use of the term "circuitry" as used herein with respect to components of a system or an apparatus should be understood to include particular hardware configured to perform the functions associated with the particular circuitry as described herein. The term "circuitry" should be understood broadly to include hardware and, in some embodiments, software for configuring the hardware. For example, in some embodiments, "circuitry" may include processing circuitry, communications circuitry, input/output circuitry, and the like. In some embodiments, other elements may provide or supplement the functionality of particular circuitry.

Various embodiments of the present invention are directed to improved HEMT, including manufacturing a normally-on or normally-off HEMT with an in situ plasma treatment before Al2O3 deposition for improved Ron during manufacturing.

Normally-off GaN HEMTs may include a p-GaN gate that is doped with Mg. The p-doped gate allows for depletion of the electrons to have a normally-off device. A normally-off HEMT power device requires a voltage to be applied to the gate to transition or switch the HEMT power device to an on-state and conducting current.

To form a p-doped GaN gate a wafer with a silicon dioxide layer underneath a GaN layer that is underneath an AlGaN layer may have a GaN layer grown or formed on top. This top GaN layer may be doped with Mg to for a p-type doped GaN layer. The AlGaN may be then impacted by the Mg diffusion into the AlGaN layer during the growth of the p-type GaN. The p-GaN layer may be etched to form the p-GaN gate. However, the 2DEG sheet resistance of the finished power device is significantly affected by the p-GaN growth and etching, including increasing the resistance of Ron. This is due to the p-GaN etching damaging the surface of the AlGaN layer. The surface is damaged because etching the p-GaN layer on the AlGaN layer is not perfectly selective to only etching the p-GaN layer without impacting the AlGaN layer.

In accordance with the present invention, improving the Ron of the power device may be done by reducing the 2DEG Rsh, particularly in one or more regions where there has been p-GaN etching.

An aluminum oxide layer may also be deposited over the region that receives the plasma treatment containing hydrogen such as H2 and NH3, diluted in Ar and N2. Deactivation after pGaN etch of Mg in-diffused in the second portion of the AlGaN layer may reduce the 2DEG sheet resistance. In a hydrogen rich environment temperature, the hydrogen atom forms a Mg-H complex, thereby preventing Mg from acting as an acceptor. The aluminum oxide layer may also improve the Ron. Successful surface passivation by aluminum oxide prevents the surface states from being neutralized by trapped electrons and leads to improved 2DEG sheet resistance.

In various embodiments, an in situ plasma treatment is utilized to deactivate Mg in the AlGaN layer. During the in situ plasma treatment a region including a p-GaN gate is covered by a dielectric (e.g., silicon dioxide layer and aluminum oxide) to protect the region from the plasma treatment and, thus, not deactivate the Mg in this region. Additionally or alternatively, various embodiments include a plurality of aluminum oxide layers, including an aluminum oxide layer in contact with the AlGaN layer that decreases the 2DEG sheet resistance (Rsh), which improves Ron. By reducing the 2DEG Rsh the power required to transition the normally-off power device to an on state may be reduced. Additionally or alternatively, the area consumption may be reduced by reducing the amount of distance needed for plasma treatment.

Additionally or alternative, another advantage of the present invention is that the plasma treatment may be applied in situ before a passivation layer deposition. This in situ plasma treatment simplifies process flow and avoids additional manufacturing time associated with ex-situ cleaning treatment and passivation operations that may affect an exposed surface.

The power devices of the present invention may be used in a myriad of applications. For example, various embodiments may be used in 100V to 650V p-GaN HEMTs used in DC-DC convertor applications.

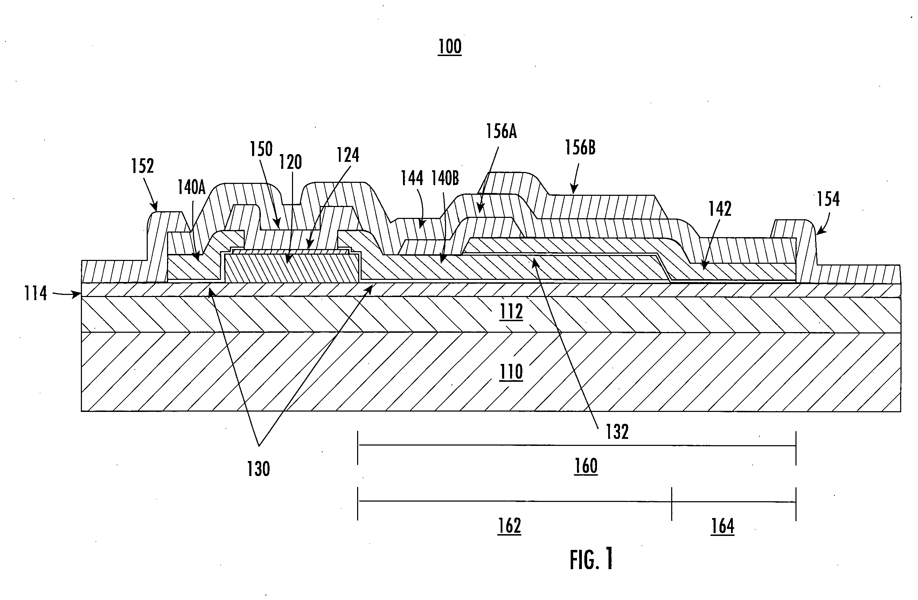

FIG. 1 illustrates a first cross-section view of a block diagram of a first exemplary power device in accordance with one or more embodiments of the present invention. The exemplary power device illustrated in FIG. 1 is after manufacturing operations of exemplary methods have been completed, which are described further herein.

As illustrated in FIG. 1, a power device 100 may include a normally-off p-GaN HEMT. The power device 100 may be on top of a silicon dioxide layer 110 that is beneath a p-GaN layer 112, that is beneath an AlGaN layer 114. Above the AlGaN layer 114 is a p-GaN gate 120. The p-GaN gate 120 may have initially been a portion of a p-GaN layer that was etched to leave the region of the p-GaN gate 120. For example, a wafer may be provided with the silicon dioxide layer 110, the p-GaN layer 112, and the AlGaN layer 114. This p-GaN layer that includes the region of the p-GaN gate 120 may be grown or formed as a GaN layer on the AlGaN layer 114 and then implanted with Mg to form this p-GaN layer. To form the p-GaN gate 120, this p-GaN layer may be etched so that only the p-GaN gate 120 remains of the power device 100 remains.

In various embodiments, the p-GaN gate 120 may have a TiN layer 124 on top the of the p-GaN gate 120. A first aluminum oxide layer 130 is deposited on the sidewalls of the p-GaN gate 120 and around the p-GaN gate. A first silicon dioxide layer 140 may be deposited above the first aluminum oxide layer 130, which is shown in the cross section view of as 140A and 140B.

The normally off p-GaN HEMT of power device 100 may include a gate, a source, and a drain. The metal contact of the gate of the normally-off p-GaN HEMT is illustrated as metallization layer 150. The metal contact of the source of the normally-off p-GaN HEMT is illustrated as metallization layer 152. The metal contact of the drain of the normally-off p-GaN HEMT is illustrated as metallization layer 154. The normally-off p-GaN HEMT 102 may also include one or more other metal shielding(s) 156 (e.g., 156A, 156B) that are for controlling electrical fields generated when the power device is operated.

The gate of the normally off p-GaN HEMT is located a separation distance 160 from the drain of the normally off p-GaN HEMT. The separation distance includes a first distance 162 and a second distance 164. The first distance 162 is the distance from the p-GaN gate 120 to the end of the first aluminum oxide layer 130. The second distance 1644 is the distance from the end of the first aluminum oxide layer 130 to the metallization layer 154 associated with the drain. This second distance 164 is also the distance of the AlGaN layer 114 that is directly covered by a second aluminum oxide layer 132 that is deposited on to, among other things, the AlGaN layer 114. This portion of the AlGaN layer 114 was exposed by operations described further herein to allow for the in situ plasma pretreatment over this portion of the AlGaN layer 114.

By controlling the first distance 162 and the second distance 164 in conjunction with the first aluminum oxide layer 130 covering the first distance 162, the portion of the AlGaN layer 114 exposed to the in situ plasma treatment may be controlled. This allows for tailoring of two-dimensional electron gas (2DEG) by splitting the aluminum oxide layer 130 deposition distance. Additionally, by having the aluminum oxide layer 130 on the sidewalls of the p-GaN gate 120 that controls for the 2DEG under and around the p-GaN gate 120, which lowers the electric field at the corner of the p-GaN gate 120 of the power device 100. This also prevents the Mg in and around the p-GaN gate 120 from being deactivated by the plasma treatment and allows for selective reduction in 2DEG Rsh.

This first aluminum oxide layer 130 may be referred to as an aluminum oxide stop etch layer.

In various embodiments, the first distance 162 may be a distance of 200 nm or more (e.g., 200 nm to 300 nm). The distance may be related to the thermal process with hydrogen diffusion during the plasma treatment. The Mg deactivation may depend on the conditions of the thermal process, which may cause both vertical and some horizontal deactivation. The first distance 162, for example, is to be far enough away to avoid hydrogen diffusion up to the p-GaN gate 120. The first distance 162 may also depend on the structure and/or power class (e.g., voltage rating) of the power device 100. E.g., at 650 V rating for the power device 100 the separation distance 160 between the gate and the drain may be 17-18 and the first distance 160 may be 1 micron and the second distance 162 to the gate of 16-17 microns. If have a lower rating of the power device 100 then may need to adjust distances.

As also illustrated in FIG. 1, there may be a second silicon dioxide layer 142 and a third silicon dioxide layer 144. These additional silicon dioxide layers may be deposited on the various layers of the power device 100 illustrated, which is described further herein.

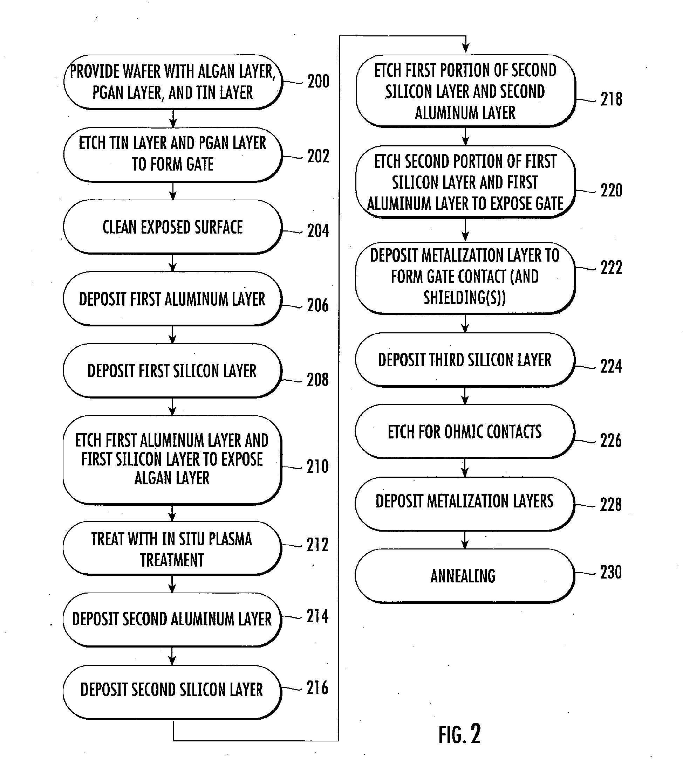

FIG. 2 illustrates a first example flowchart of operations for manufacturing a power device in accordance with one or more embodiments of the present disclosure. The manufacturing of a power device of a normally off p-GaN HEMT may be a part of a method of manufacturing an integrated circuit.

At operation 200, a wafer with an AlGaN layer covered, a p-GaN layer, and a TiN layer is provided. The wafer may also include a GaN layer 112 under the AlGaN 114 and a silicon dioxide layer 110 may be under the GaN layer 112. The p-GaN layer may be used to form the p-GaN gate 120. This p-GaN layer may also be covered by a TiN layer 124.

In various embodiments the wafer may be provided with the silicon dioxide layer 110, the GaN layer 112, and the AlGaN layer 114. Then, a top or second GaN layer may be grown or formed on the AlGaN layer 114. Then, this top or second GaN layer may be doped with Mg to form a p-GaN layer that will be etched. The TiN layer 124 may be deposited on the p-GaN layer.

At operation 202, the TiN layer and p-GaN layer are etched to form a gate. The p-GaN gate 120 may be etched, which may include the p-GaN gate 120 and the TiN layer 124. The p-GaN layer may be etched in Cl-based chemistry. The TiN layer 124 may be etched with BCl3. In various embodiments, performing the etching may include TiN lateral recess by wet etch with SiN HM, resist strip in O2/N2 plasma, and polymer removal.

At operation 204, an exposed surface is cleaned. This cleaning operation will clean the exposed surface of the AlGaN layer 114 and the p-GaN gate 120 and TiN layer 124. In various embodiments, the cleaning may utilize hot HCl and/or HF.

At operation 206, a first aluminum oxide layer is deposited. A first aluminum oxide layer 130 may be deposited over the AlGaN layer 114, the p-GaN gate 120, and the TiN layer 124. In various embodiments, the aluminum oxide layer may be Al2O3 to a thickness of few nanometers deposited by atomic layer deposition (ALD) a thermal or a plasma process. The thickness may be varied. Other examples may include 2.5 nm to 11 nm. The ALD layer may include aluminum oxide, hafnium oxide, silicon dioxide, silicon nitride and aluminum nitride.

At operation 208, a first silicon dioxide layer is deposited. In various embodiments the first silicon dioxide layer 140 may be PECVD SiO2 at thickness of 300 nm. The first silicon dioxide may be PECVD silicon nitride, LPCVD SiO2 and LPCVD SiN.

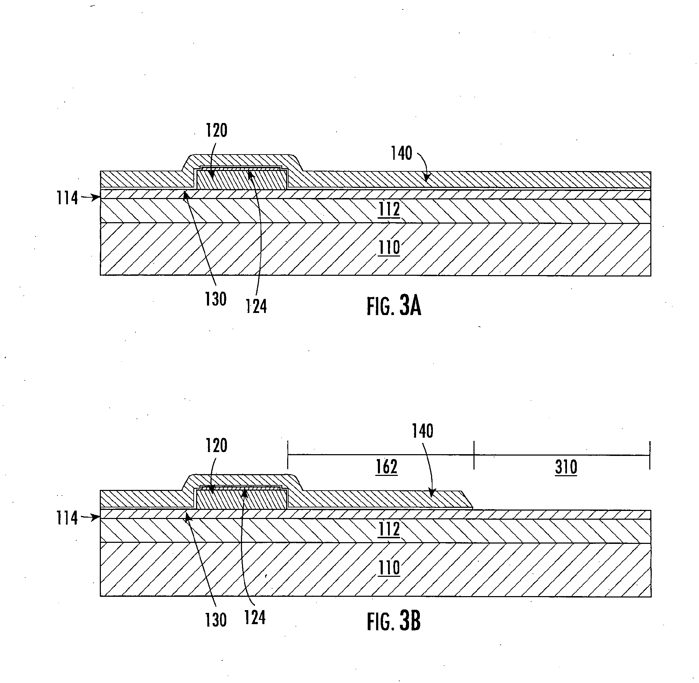

An illustration of the wafer after operation 208 is illustrated in FIG. 3A.

At operation 210, the first silicon dioxide layer and the first aluminum oxide layer are etched to expose the AlGaN layer. The etching of the first silicon dioxide layer 140 and the first aluminum oxide layer 130 may remove these layers over an exposed portion 310 of the AlGaN layer 114. The exposed portion 310 will include at least the second distance 164. The exposed portion 310 of the AlGaN layer 114 will begin the first distance 162 away from the p-GaN gate 120. The first distance 162 may be based on the distance to avoid introducing hydrogen diffusion into the area around and at the p-GaN gate 120 during the in-situ plasma treatment operation. This etching may utilize CF4-based chemistry on the AlGaN layer 114, resist stripping with O2/N2 plasma, and/or polymer removal.

At operation 212, in-situ plasma treatment is performed. The in-situ-plasma treatment may be applied to the exposed first portion 310 of the AlGaN layer 114. The in-situ plasma treatment may utilize a hydrogen-based plasma treatment. The in-situ plasma treatment accelerates Mg deactivation through introduction of hydrogen (H) that forms a Mg-H complex formation and this deactivates the Mg doping of the exposed portion 310 of the AlGaN layer 114, which may reduce the 2DEG sheet resistance (Rsh) of the AlGaN/GaN heterostructure.

In various embodiments, the in-situ plasma treatment is performed, for example, on a wafer in a direct plasma chamber with NH3/N2 flow or H2/N2 and with a power range between 150 and 300 W. Additionally or alternatively, a temperature in the range of 300°C may accelerate Mg deactivation through introduction of hydrogen. By modifying the conditions of operation 212 to diffuse additional hydrogen and/or deactivate greater amounts of Mg then the Vth may be further decreased.

During the in-situ plasma treatment the p-GaN gate 120 is protected by the silicon dioxide layer 140 and the first aluminum oxide layer 130.

An illustration of the wafer after operation 212 is illustrated in FIG. 3B.

At operation 214, deposit second aluminum oxide layer. A second aluminum oxide layer 132 is deposited. For the first portion 310 of the wafter the second aluminum oxide layer 132 will cover the AlGaN layer 114. Outside of the first portion 310 of the wafer the second aluminum oxide layer 132 is deposited on the first silicon dioxide layer 140.

In various embodiments the second aluminum oxide layer 132 may be of a different thickness than the first aluminum oxide layer 130. This may be a second aluminum oxide layer thickness of the second aluminum oxide layer 132 while the first aluminum oxide layer 130 has a first aluminum oxide layer thickness. The second aluminum oxide layer thickness may be, for example, 3 nm, 5 nm, 7 nm, or the like. A change in thickness of the second aluminum oxide layer 132 may be associated with different gate leakages. Though the gate leakage will also depend on other aspects of the power device, including the profile of the p-GaN gate 120. In various embodiments, the second aluminum oxide layer 132 may be an ALD Al2O3 deposition.

At operation 216, deposit second silicon dioxide layer. The second silicon dioxide layer 142 may be deposited. In various embodiments the second silicon dioxide layer may be PECVD SiO2 at thickness of 300 nm. The first silicon dioxide may be PECVD silicon nitride, LPCVD SiO2 and LPCVD SiN.

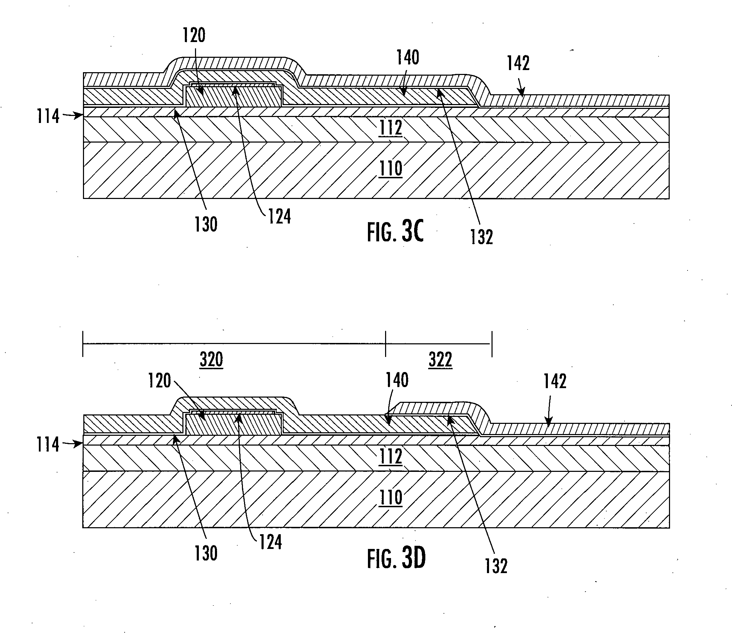

An illustration of the wafer after operation 216 is illustrated in FIG. 3C.

At operation 218, etch a first portion of the second silicon dioxide layer and the second aluminum oxide layer. The etching may be at a second portion 320 of the wafer that is etched to remove the second silicon dioxide layer 142 and the second aluminum oxide layer 132 to expose first silicon dioxide layer 140 over and around the p-GaN gate 120 while leaving the second silicon dioxide layer 142 and the second aluminum oxide layer 132 covering the AlGaN layer 114 at portion 310. The removal of the second silicon dioxide layer 142 and the second aluminum oxide layer 132 is to prevent there being double silicon dioxide layers over the p-GaN gate 120, which would impact electrical performance. This etching may utilize CF4-based chemistry on the aluminum oxide layer 132, resist stripping with Q2/N2 plasma, and/or polymer removal.

In various embodiments, the etch may also leave an overlap of the second silicon dioxide layer 142 and second aluminum oxide layer 132 over the first silicon dioxide layer 140 and the first aluminum oxide layer 130 at an overlapping portion 322 of the wafer. This overlapping portion 322 may also be etched to include a tapering associated with a metallization layer that will be for shielding (e.g., 156A).

An illustration of the wafer after operation 218 is illustrated in FIG. 3D.

At operation 220, etch silicon dioxide layer(s) and aluminum oxide layer(s) to expose first gate. The etching may be at a third portion 330 of the wafer that is etched to remove the first silicon dioxide layer 140 and the first aluminum oxide layer 130 to expose the p-GaN gate 120 and TiN layer 124. This etching may utilize CF4-based chemistry, resist stripping with O2/N2 plasma, polymer removal, and/or pre-metal cleaning.

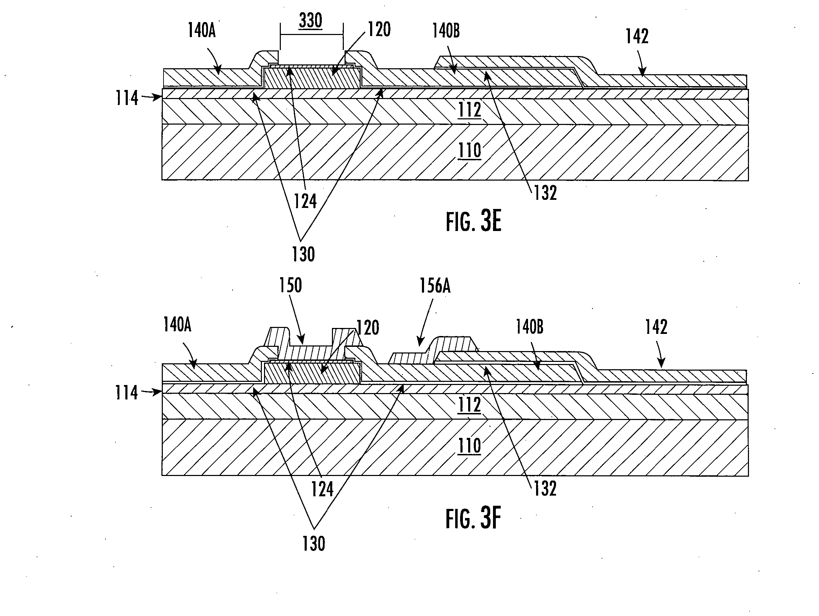

An illustration of the wafer after operation 220 is illustrated in FIG. 3E.

At operation 222, deposit metallization layer to form gate contact and one or more shielding. One or more metallization layers may be deposited to form gate contact 150 for the p-GaN gate 120 as well as a metal shielding 156A. This metallization layer deposition may utilize TiN/AlCu/TiN or W metallization and/or taper etching. The gate contacts 150A, 150B may be self-aligned.

An illustration of the wafer after operation 222 is illustrated in FIG. 3F.

At operation 224, deposit third silicon dioxide layer. In various embodiments, a third silicon dioxide layer 144 may be deposited. In various embodiments the third silicon dioxide layer may be PECVD SiO2. The first silicon dioxide may be PECVD silicon nitride, LPCVD SiO2 and LPCVD SiN.

At operation 226, etch for ohmic contacts. The etching for the ohmic contacts may include etching the silicon dioxide layers and/or aluminum oxide layers to expose the AlGaN layer 114 for making the source contact 152 and drain contact 154. This etching may utilize CF4-based chemistry on the AlGaN, Cl-based chemistry for the AlGaN recess, resist stripping with O2/N2 plasma, polymer removal, and/or pre-metal cleaning.

At operation 228, deposit metallization layer(s) for ohmic contacts (and shielding). This metallization layer may be deposited to form the source contact 152 and drain contact 154. In various embodiments, this metallization layer may also include one or more shielding metal portions deposited (e.g., 156B). This metallization layer deposition may utilize Ti, Ta, AlCu,TiN metallization.

At operation 230, annealing is performed. The annealing may be ohmic annealing.

An illustration of the wafer after operation 230 is illustrated in FIG. 1.

In various embodiments, the operations after the in-situ plasma treatment may be referred to as forming gates, sources, and drains of HEMTs as each of the operations goes to forming one or more structures needed for forming an HEMT power device 100.

It will be appreciated that the operations above may be iterated, omitted, or varied. For example, various embodiments may omit the deposition of one or more aluminum oxide layers.

FIGs. 3A-3H illustrate example block diagrams associated with operations for manufacturing a power device in accordance with one or more embodiments of the present invention.

FIG. 3A illustrates a wafer after performance of operation 208.

FIG. 3B illustrates a wafer after performance of operation 212.

FIG. 3C illustrates a wafer after performance of operation 216.

FIG. 3D illustrates a wafer after performance of operation 218.

FIG. 3E illustrates a wafer after performance of operation 220.

FIG. 3F illustrates a wafer after performance of operation 222.

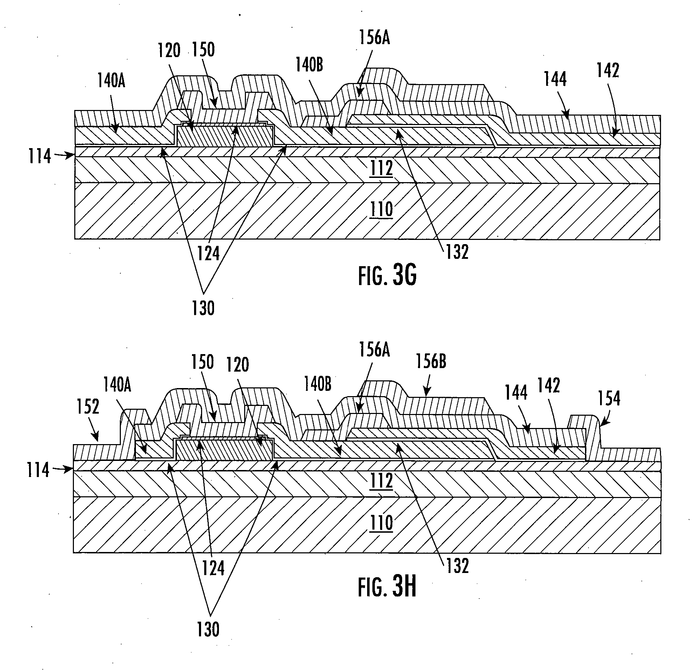

FIG. 3G illustrates a wafer after performance of operation 224.

FIG. 3H illustrates a wafer after performance of operation 228.

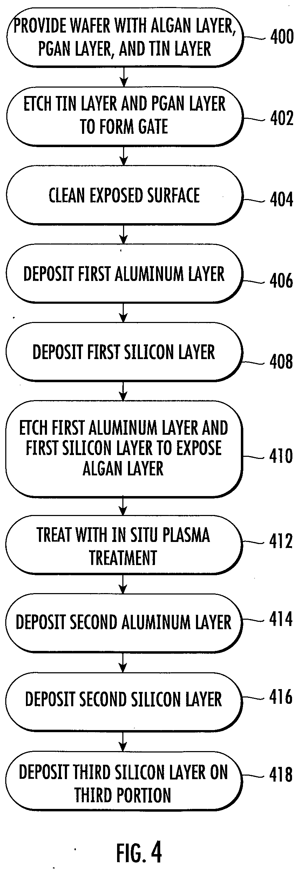

FIG. 4 illustrates a second example flowchart of operations for manufacturing a power device in accordance with one or more embodiments of the present invention.

At operation 400, a wafer with an AlGaN layer covered, a p-GaN layer, and a TiN layer is provided. Operation 400 may be the same as operation 200.

At operation 402, the TiN layer and p-GaN layer are etched to form a gate. Operation 402 may be the same as operation 202.

At operation 404, an exposed surface is cleaned. Operation 404 may be the same as operation 204.

At operation 406, a first aluminum oxide layer is deposited. Operation 406 may be the same as operation 206.

At operation 408, a first silicon dioxide layer is deposited. Operation 408 may be the same as operation 208.

At operation 410, the first silicon dioxide layer and the first aluminum oxide layer are etched to expose the AlGaN layer. Operation 410 may be the same or similar as operation 210 except that the portion exposed may be at a portion 320A that is larger than portion 320. In this manner the distance from the p-GaN gate 120 to the start of the portion 320A is smaller.

At operation 412, perform in situ-plasma treatment. Operation 412 may be the same as operation 212.

At operation 414, deposit second aluminum oxide layer. Operation 414 may be the same or similar as operation 214 expect that the aluminum oxide layer 132 may be hafnium oxide, silicon dioxide, silicon nitride and aluminum nitride. In various embodiments, the layer may be deposited at a thickness of few nanometers.

At operation 416, deposit second silicon dioxide layer. Operation 416 may be the same as operation 216.

At operation 418, deposit third silicon dioxide layer on third portion. Operation 418 may be distinct from an operation performed in FIG. 2. In operation 418 a silicon dioxide layer 520 may be deposited on a third portion 530 of the wafer. The silicon dioxide layer 520 may SiN with a thickness of 80 nm.

In various embodiments, subsequent to operation 418, additional operations for forming gates, sources, and drains of HEMTs may be performed.

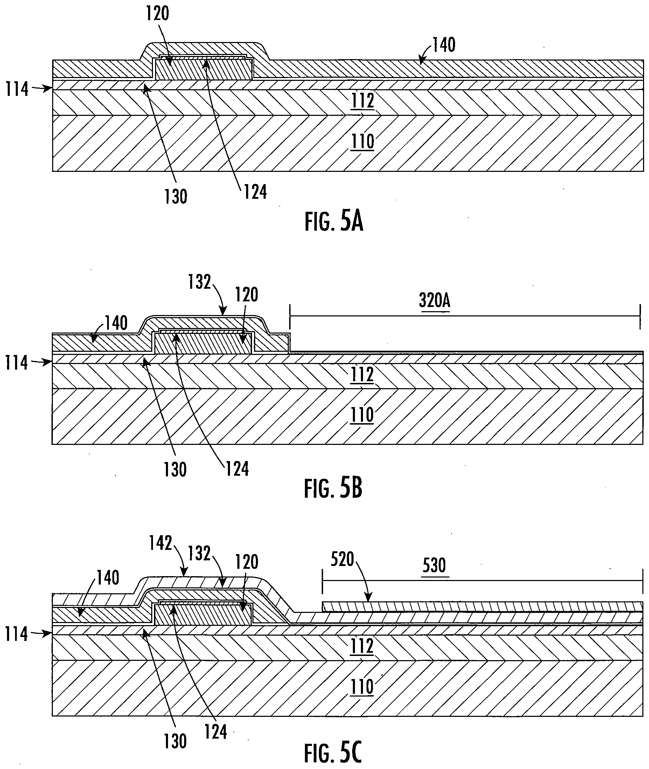

FIGs. 5A-5C illustrate example block diagrams associated with operations for manufacturing a power device in accordance with one or more embodiments of the present invention.

FIG. 5A illustrates a wafer after performance of operation 408.

FIG. 5B illustrates a wafer after performance of operation 412.

FIG. 5C illustrates a wafer after performance of operation 416.

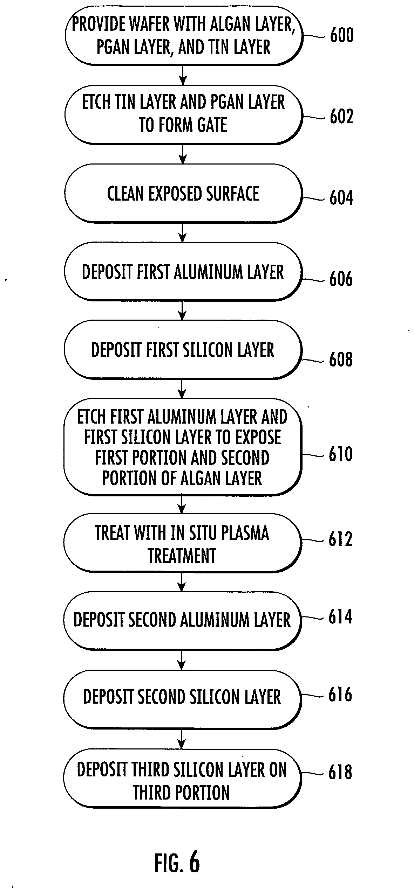

FIG. 6 illustrates a third example flowchart of operations for manufacturing a power device in accordance with one or more embodiments of the present invention.

At operation 600, a wafer with an AlGaN layer covered, a p-GaN layer, and a TiN layer is provided. Operation 600 may be the same as operation 200.

At operation 602, the TiN layer and p-GaN layer are etched to form a gate. Operation 602 may be the same as operation 202.

At operation 604, an exposed surface is cleaned. Operation 604 may be the same as operation 204.

At operation 606, a first aluminum oxide layer is deposited. Operation 606 may be the same as operation 206.

At operation 608, a first silicon dioxide layer is deposited. Operation 608 may be the same as operation 208:

At operation 610, the first silicon dioxide layer and the first aluminum oxide layer are etched to expose a first portion and a second portion of the AlGaN layer. Operation 610 may be the same or similar as operation 210 except that a first portion 710 and a second portion 720 of the AlGaN layer 114 are exposed on both sides of the of the p-GaN gate 120. Additionally, the etching leaves spacers 142A, 142B around the p-GaN gate 120. The spacers 142A, 142B are comprised of portions of the first silicon dioxide layer 140 and the first aluminum oxide layer 130.

At operation 612, perform in situ-plasma treatment. Operation 612 may be the same as operation 212.

At operation 614, deposit a second aluminum oxide layer. Operation 614 may be the same or similar as operation 214 expect that the aluminum oxide layer 732 may be an AlN layer, which may cover the spacers 140A, 140B along with the p-GaN gate 120 and TiN layer 124. In various embodiments, the AlN layer may be deposited at a thickness of 5 nm at a temperature of 370°C.

At operation 616, deposit second silicon dioxide layer. Operation 616 may be the same as operation 216.

At operation 618, deposit third silicon dioxide layer on third portion. Operation 418 may be distinct from an operation performed in FIG. 2. In operation 418, a silicon dioxide layer 520 may be deposited on a third portion 530 of the wafer. The silicon dioxide layer 520 may SiN with a thickness of 80 nm.

In various embodiments, subsequent to operation 618, additional operations for forming gates, sources, and drains of HEMTs may be performed.

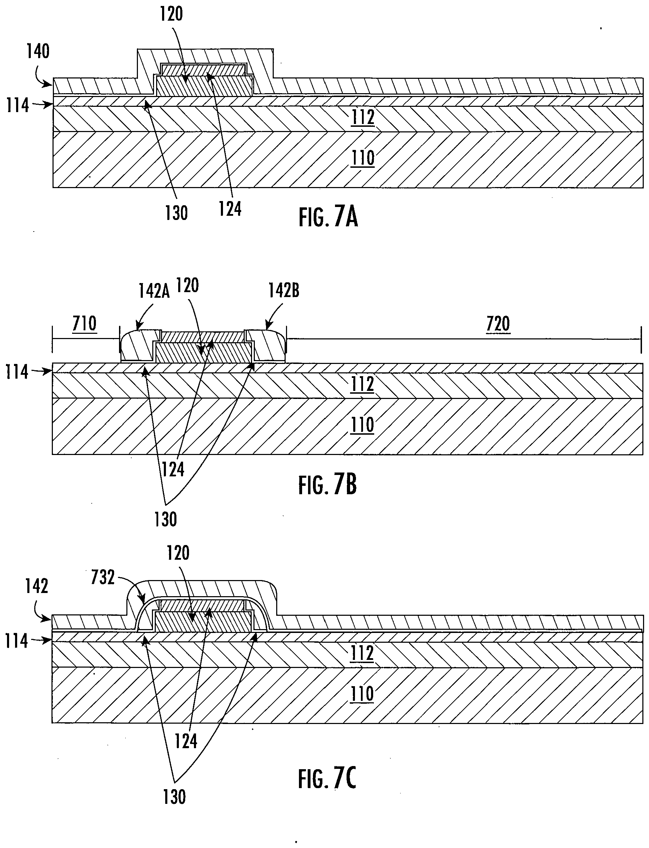

FIGs. 7A-7C illustrate example block diagrams associated with operations for manufacturing a power device in accordance with one or more embodiments of the present invention.

FIG. 7A illustrates a wafer after performance of operation 608.

FIG. 7B illustrates a wafer after performance of operation 612.

FIG. 7C illustrates a wafer after performance of operation 616.

It should be readily appreciated that the embodiments of the systems and apparatuses, described herein may be configured in various additional and alternative manners in addition to those expressly described herein.

Operations and/or functions of the present invention have been described herein, such as in flowcharts. The flowchart blocks support combinations of means for performing the specified operations and/or functions and combinations of operations and/or functions for performing the specified operations and/or functions.

While this specification contains many specific embodiments and implementation details, these should not be construed as limitations on the scope of the invention as defined by the claims, but rather as descriptions of features specific to particular embodiments of particular disclosures. Certain features that are described herein in the context of separate embodiments can also be implemented in combination in a single embodiment. Conversely, various features that are described in the context of a single embodiment can also be implemented in multiple embodiments separately or in any suitable subcombination. Moreover, although features may be described above as acting in certain combinations and even initially claimed as such, one or more features from a claimed combination can in some cases be excised from the combination, and the claimed combination may be directed to a subcombination or variation of a subcombination.

While operations and/or functions are illustrated in the drawings in a particular order, this should not be understood as requiring that such operations and/or functions be performed in the particular order shown or in sequential order, or that all illustrated operations be performed, to achieve desirable results. In certain circumstances, operations and/or functions in alternative ordering may be advantageous. In some cases, the actions recited in the claims may be performed in a different order and still achieve desirable results. Thus, while particular embodiments of the subject matter have been described, other embodiments are within the scope of the following claims.

While this detailed description has set forth some embodiments of the present invention, the appended claims cover other embodiments of the present invention which differ from the described embodiments according to various modifications and improvements.

## Claims

1. A method for manufacturing an integrated circuit comprising:
providing (200; 400; 600) a wafer comprising a AlGaN layer (114) with a first surface and a p-GaN layer on the first surface of the AlGaN layer;
etching (202; 402; 602) the p-GaN layer to form at least a first p-GaN gate (120);
depositing (206; 406; 606) a first aluminum oxide layer (130) over the first p-GaN gate;
depositing (208; 408; 608) a first silicon dioxide layer (140) over the first aluminum oxide layer;
etching (210; 410; 610) the first silicon dioxide layer (140) and the first aluminum oxide layer (130) to expose a first portion (310; 320A; 720) of the AlGaN layer (114) starting a first distance (162) from the first p-GaN gate;
treating (212; 412; 612) the first portion of the AlGaN layer with an in-situ plasma treatment, wherein the in-situ hydrogen-based plasma treatment deactivates magnesium in the first portion of the AlGaN layer; and
forming at least a first normally-off HEMT (100), wherein a gate of the first normally-off HEMT is the first p-GaN gate (120).

2. The method of claim 1, wherein forming the first normally-off HEMT comprises depositing (214, 216; 414, 416; 614, 616) at least a second aluminum oxide layer (132) and a second silicon dioxide layer (142).

3. The method of claim 1 or 2, wherein treating the first portion of the AlGaN layer with the in-situ plasma treatment does not deactivate Mg in a portion of the AlGaN layer (114) under the first p-GaN gate (120).

4. The method of any of the preceding claims, wherein the in-situ plasma treatment comprises diffusing hydrogen into the first portion of the AlGaN layer.

5. The method of any of the preceding claims, wherein the first distance (162) is at least 200 nm.

6. The method of any of the preceding claims, wherein forming the first normally-off HEMT further comprises depositing (222; 228) metallization layers associated with a first normally-off HEMT gate (150), a first normally-off HEMT source (152), and a first normally-off HEMT drain (154).

7. The method of any of the preceding claims, wherein forming the first normally-off HEMT further comprises depositing at least a first metal shielding layer (156).

8. The method of any of the preceding claims, wherein the p-GaN gate (120) comprises a TiN layer (124).

9. The method of any of the preceding claims, further comprising:
depositing, after etching the first silicon dioxide layer and the first aluminum oxide layer but prior to the in-situ plasma treatment, a third aluminum oxide layer over the p-GaN gate.

10. The method of any of the preceding claims, wherein etching the first silicon dioxide layer and the first aluminum oxide layer further exposes a second portion (710) of the AlGaN layer a second distance from a second side of the p-GaN gate (120); and
wherein treating the first portion (720) of the AlGaN layer with the in-situ plasma treatment further comprises treating the second portion of the AlGaN layer with the in-situ plasma treatment.

11. A normally-off HEMT (100) comprising:
a p-GaN gate (120) on an AlGaN layer (114);
wherein the p-GaN gate is covered by a first aluminum oxide layer (130) and a first silicon dioxide layer (140);
wherein the AlGaN layer is comprised of a first portion (310; 320A; 720) of the AlGaN layer starting a first distance (162) from the first p-GaN gate, and where the first portion of the AlGaN layer is not covered by the first aluminum oxide layer or the first silicon dioxide layer; and
wherein the first portion of the AlGaN layer has deactivated Mg, in particular deactivated from an in-situ hydrogen-based plasma treatment.

12. The normally off HEMT of claim 11, wherein a portion of the AlGaN layer (114) under the first p-GaN gate (120) comprises Mg that is not deactivated.

13. The normally off HEMT of claim 11 or 12, wherein the deactivated Mg is comprised of Mg-H complexes, in particular Mg-H complexes from diffused hydrogen from the in-situ plasma treatment.

14. The normally off HEMT of any of claims 11-13, wherein the p-GaN gate comprises a TiN layer.

15. The normally off HEMT of any of claims 11-14, wherein the AlGaN layer is further comprised of a second portion of the AlGaN layer starting a second distance from the first p-GaN gate on an opposite side of the p-GaN gate then the first portion of the AlGaN layer, and where the second portion of the AlGaN layer is not covered by the first aluminum oxide layer or the first silicon dioxide layer; and
wherein the second portion of the AlGaN layer has deactivated Mg, in particular deactivated from the in-situ hydrogen-based plasma treatment.
